# EUROPEAN PATENT SPECIFICATION

(11) **EP 3 330 798 B1**
(45) Date of publication and mention of the grant of the patent: **30.12.2020**
(21) Application number: 16829728.1
(22) Date of filing: 28.06.2016
(51) Int. Cl.: G03F 7/20

(54) **MASKLESS PHOTOLITHOGRAPHIC SYSTEM IN COOPERATIVE WORKING MODE FOR CROSS-SCALE STRUCTURE**
MASKENLOSES PHOTOLITHOGRAPHISCHES SYSTEM IN KOOPERATIVEM BETRIEBSMODUS FÜR SKALENÜBERGREIFENDE STRUKTUR
SYSTÈME DE PHOTOLITHOGRAPHIE SANS MASQUE EN MODE DE FONCTIONNEMENT COOPÉRATIF DE STRUCTURE INTER-ÉCHELLE

(30) Priority: 27.07.2015 CN 201510446458
(43) Date of publication of application: 06.06.2018
(73) Proprietor: Technical Institute of Physics and Chemistry of the Chinese Academy of Sciences, Haidian District Beijing 100190 (CN)
(72) Inventor: DUAN, Xuanming, Beijing 100190 (CN); DONG, Xianzi, Beijing 100190 (CN); ZHENG, Meiling, Beijing 100190 (CN)
(74) Representative: Serjeants LLP
(86) International application number: PCT/CN2016/087415
(87) International publication number: WO 2017/016362

(56) References cited:
- EP-A2- 0 841 681
- WO-A1-01/39269
- CN-A- 101 063 809
- CN-A- 101 216 663
- CN-A- 102 000 912
- CN-A- 102 621 823
- US-A- 5 670 280
- US-A1- 2013 308 111
- US-B1- 6 285 002
- US-B1- 6 894 762

## Description

### Technical Field

The present invention relates to the technical field of photolithography, in particular to a maskless photolithographic system in cooperative working mode for cross-scale structures.

### Background of the Invention

For a practical micro-nano device, it not only needs manufacture of a high-precision micro-nanostructure with a key function but also manufacture of a large-area macrostructure capable of being connected with an external input/output signal. Co-existence of multi-scale structures cannot be avoided in a micro-nano device manufacturing process. For example, in a typical fin field effect transistor structure, the size of a source and a drain connected with an external electrode is about greater than 100µm^{∗}100µm, but the characteristic size of a fin structure connected between the source and the drain is about 20nm^{∗}100nm, i.e., a ratio of the large-area source and drain structures with a micron-scale precision to the fin structure with a nano-scale precision is 5000000:1. For another example, in a structure of a photonic crystal demultiplexer, the area of a light incidence waveguide/emergence waveguide with a micron-scale precision is about 198000µm², but the area of a high-precision structure with a nano-scale precision is 4500µm², and a ratio of the incidence waveguide/emergence waveguide area to the area of the high-precision structure is 44:1.

At present, a micro-nano structure or device containing multi-scale structures is usually manufactured sequentially by adopting various methods in turn. For example, ultraviolet mask photolithography is adopted for manufacturing a large-area micro-scale-precision structure, and then photolithography such as electron beam photolithography is adopted for manufacturing a nano-scale structure. When exposure is performed sequentially by adopting these various methods, an alignment mark needs to be made on a substrate material, and an optical system needs be used for observing splicing in an overlay process of structures manufactured by adopting different methods. Further, the splicing precision is further restricted by imaging resolution of the observation system. Additionally, a masking plate needs be manufactured through electron beam photolithography point-by-point scanning for each designed structure. Hence the period of the device manufacturing process is long, the technology is complex and the cost is high. When a single high-precision processing technique (such as an electron beam point-by-point scanning) is used for manufacturing, the manufacturing time will be very long and the efficiency is lower.

Maskless photolithography techniques based on plane projection exposure of a spatial light modulator (such as DMD plane projection photolithography) are suitable for manufacturing a submicron-scale precision two-dimensional or three-dimensional large-area complex structure, and laser direct writing techniques (such as a femto-second laser two-photon fabrication technique) are suitable for fabricating small-area nano-scale two-dimensional or real three-dimensional structures. These two techniques both are realized by directly processing graphic data and controlling the movement of a mobile station or the deflection of a DMD micro-mirror through a computer according to a data document. Since these two methods both use photon beam processing and spatial environment requirements for realizing them are the same, the two methods can be integrated and used for realizing one-step formation of cross-scale complex structures. Up to now, there have been no systems or methods for realizing cross-scale structure processing by combining these two techniques.

US 6,894,762 relates to dual source lithography of semiconductor wafers. More particularly, it relates to lithography using two lithography exposure sources to form a pattern. The dual source lithography system includes a next generation lithography (NGL) module using laser direct writing as a laser point-to-point scanning exposure unit. A conventional optical photolithographic system using a photomask may be used as a plane projection exposure unit. The dual source lithography system includes a stage and a computer system as a calculation and control unit.

In a specific embodiment, the dual source lithography system includes a conventional optical lithography module for non-critical optical lithography exposure and an e-beam lithography module for direct e-beam writing of printed features onto photoresist layers (i.e., critical pattern formation). The system includes dual stages for transferring wafers between lithography modules. The two stages may be arranged in any suitable configuration for transferring a wafer to or from the first (e.g., conventional optical) photolithographic module to or from the second (e.g., e-beam) lithographic module for sequential pattern formation on the same photoresist layer. A light source provides illumination of the non-critical patterns in the conventional optical lithography module. The light source transmits light to the optical photolithography module using mirrors. Preferably, the optical lithography module is configured to perform projection lithography using a projection lens to project a pattern appearing on the photomask onto the wafer supported by the stage. In addition to exposing the non-critical components of the pattern, the optical lithography module preferably performs alignment and focusing, such as through the use of alignment module and automatic focusing (AF) module. By preferably focusing and aligning the wafer in the optical lithography module, the speed offered by this module increases the overall throughput. Since the optical module is the fastest, all of the focus and alignment mapping are preferably performed in this module. As described, where the wafer is not removed from the chuck the mapped alignment data is valid for both lithographic modules. In alternative embodiments, where separate tools are used for each of the two lithographic modules, the alignment and focusing will be performed in both modules. As is typical in an optical lithography system, a stepper motor or linear motor positions the wafer under the projection lens assembly.

The electron beam lithography module includes an electron gun for producing an electron beam and an electro-optical column for deflecting the electron beam in a controlled manner. In general, the electron beam produced by the electron gun is electrically and magnetically deflected by a computer-controlled deflection system in the electro-optical column to write the desired pattern on the photoresist layer of the wafer located on the stage. In an alternative embodiment, critical pattern formation is formed by a laser direct write system.

EP 0841681 discloses a lithography system comprising a projection optical lithography and an electron beam lithography unit.

US 2013/0308111 discloses a lithography system comprising a projection optical lithography unit using a photomask and a projection optical lithography unit using an addressable mask.

WO 01/39269 discloses a lithography system comprising a projection optical lithography unit using a photomask and a laser direct writing unit or a projection optical lithography unit using an addressable mask.

### Summary of the Invention

The present invention provides a maskless photolithographic system in cooperative working mode for cross-scale structures according to claim 1.

Optional or non-essential features of the system are set out in the dependent claims.

### The present invention has the following beneficial effects:

1. The system and method provided by the present invention integrate the plane projection maskless exposure technique and the laser point-by-point photolithography, and realize the exposure of pattern with multi-scale structures on photosensitive materials in one photolithography execution process, which not only contain micron-scale-precision large-area structures, but also contain nano-scale-precision structures.
2. The cross-scale structures manufactured by adopting the method provided by the present invention does not need be secondarily aligned and spliced, and all model data have already been decomposed by a calculation and control unit before exposure.
3. The method provided by the present invention can realize processing of two-dimensional and three-dimensional complex structures.

### Brief Description of the Drawing

FIG. 1 illustrates a schematic diagram of a maskless photolithographic system in cooperatively working mode for a cross-scale structure according to one embodiment of the present invention.
FIG. 2 illustrates a schematic diagram of a maskless photolithographic system in cooperatively working mode for a cross-scale structure which does not form part of the present invention.
FIG. 3 illustrates a pattern to be exposed with not only a micron-scale precision pattern portion but also a nano-scale precision portion.
FIG. 4 illustrates a pattern portion with a precision smaller than or equal to 1 micron after the pattern of FIG. 3 is decomposed.
FIG. 5 illustrates a pattern portion with a precision greater than 1 micron after the pattern of FIG. 3 is decomposed.
FIG. 6 illustrates a scanning optical microscope photograph of a structure formed through exposure by using a plane projection exposure method.
FIG. 7 illustrates a scanning electron microscope photograph of a structure formed through exposure by using a laser point-by-point scanning method.
FIG. 8 illustrates a scanning electron microscope photograph of a structure formed through exposure by cooperatively using a plane projection exposure method and a laser point-by-point scanning method.

### Reference numerals

1-first light source; 2-first energy control assembly; 3-first light gate; 4-first light beam expanding lens group; 5-first reflective mirror; 6-first dichroscope; 7-second light source; 8-second energy control assembly; 9-second light gate; 10-second light beam expanding lens group; 11-light beam homogenizing assembly; 12-diaphragm; 12-second reflective mirror; 14-third reflective mirror; 15-spatial light modulator; 16-second lens; 17-second dichroscope; 18-first objective lens; 19-mobile station; 20-calculation and control unit; 21-second objective lens

### Detailed Description

The present invention will be described with reference to the drawings in combination with the preferred embodiments of the present invention. It shall be understood that many specific details such as description about optical components are provided in the description below to facilitate the comprehensive understanding about the embodiments of the present invention. However, one skilled in the art shall understand that the present invention not only is suitable for one or more specific descriptions, but also is suitable for other structural elements, wavelengths, materials, etc. The embodiments listed below in the description are exemplary instead of restrictive.

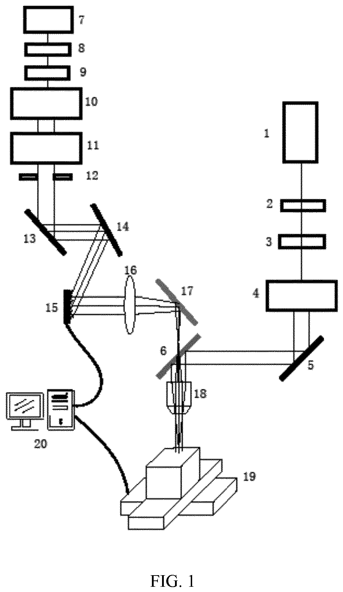

FIG. 1 illustrates a schematic diagram of a maskless photolithographic system in cooperatively working mode for a cross-scale structure according to one embodiment of the present invention. The photolithographic system comprises a laser point-by-point scanning exposure unit, a plane projection exposure unit, a mobile station 19 and a calculation and control unit 20.

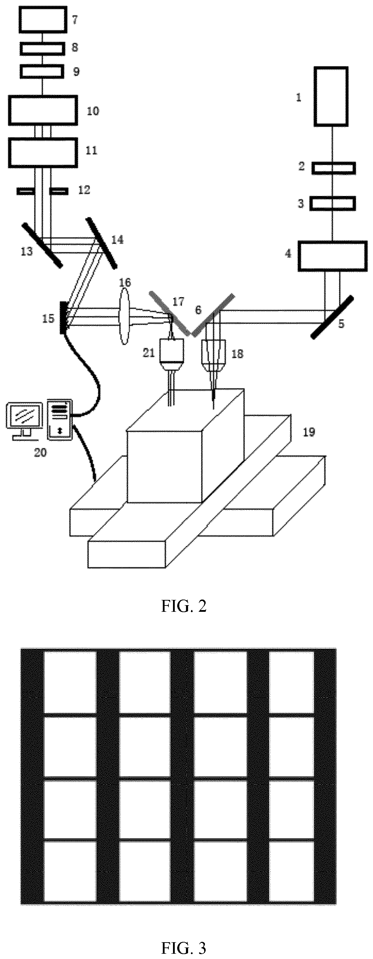

A graph document having a pattern to be exposed (as illustrated in FIG. 3) are input into the calculation and control unit20and the pattern is decomposed such that the pattern portion with a required precision below a predetermined threshold is exposed by the laser point-by-point scanning exposure unit, and the pattern portion with a required precision above the predetermined threshold is exposed by the plane projection exposure unit.

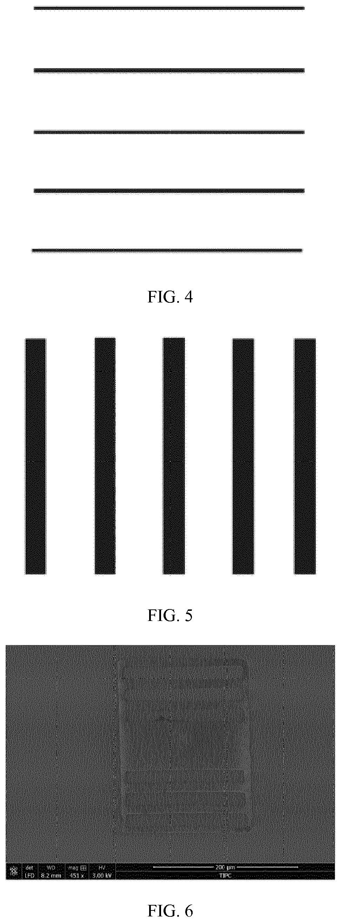

The predetermined threshold can be determined by one skilled in the art according to an actual situation. For example, in one specific example, a pattern portion with the required precision below 1µm (e.g., a portion illustrated in FIG. 4 after FIG. 3 is decomposed) is allocated to the laser point-by-point scanning exposure unit, and the calculation and control unit 20 controls the mobile station 19 to move according to data of this portion. A pattern portion with a required precision above 1µm (e.g., a portion illustrated in FIG. 5 after FIG. 3 is decomposed) is allocated to the plane projection exposure unit. It can be freely selected to allocate a pattern portion with a required precision of 1µm to the laser point-by-point scanning exposure unit or the plane projection exposure unit.

When laser point-by-point scanning exposure is performed to a sample on the mobile station, light emergent from the laser point-by-point scanning exposure unit moves relative to the sample according to the pattern with the required precision below the predetermined threshold, so as to realize the laser point-by-point scanning exposure to the sample. In one specific example of forming a three-dimensional pattern on the sample, during point-by-point scanning exposure, the point-by-point scanning exposure unit does not move, and the mobile station moves in three dimensions according to the pattern with the required precision below the predetermined threshold, such that the light emergent from the scanning exposure unit cooperates with the three-dimensional movement of the mobile station to enable the emergent light to move relative to the mobile station to realize the three-dimensional pattern. In another specific example of forming a three-dimensional pattern on the sample, the laser point-by-point scanning exposure unit can be provided with a two-dimensional galvanometer, and by using the two-dimensional galvanometer, the mobile station can achieve the purpose of realizing the three-dimensional graph through one-dimensional movement only. In one specific example of forming a two-dimensional pattern on the sample, the laser point-by-point scanning exposure unit can be provided with a two-dimensional galvanometer, and by using the two-dimensional galvanometer, the mobile station can achieve the purpose of realizing the two-dimensional pattern without moving. The use of the two-dimensional galvanometer is well known by one skilled in the art and will be further described through a specific example below.

When plane projection exposure is performed to the sample, the plane projection exposure unit enables light with a shape corresponding to the pattern portion to become emergent onto the sample according to the pattern portion with the required precision above the predetermined threshold, so as to realize the plane projection exposure to the sample.

The laser point-by-point scanning exposure unit may comprise: a first light source 1, a first energy control assembly 2, a first light gate 3, a first light beam expanding lens group 4, a first reflective mirror 5 and a first dichroscope 6.

The plane projection exposure unit may comprise: a second light source 7, a second energy control assembly 8, a second light gate 9, a second light beam expanding lens group 10, a light beam homogenizing assembly 11, a diaphragm 12, a second reflective mirror 13, a third reflective mirror 14, a spatial light modulator 15, a second lens 16 and a second dichroscope 17.

In the laser point-by-point scanning exposure unit, the light emitted by the first light source 1 is expanded by the first light beam expanding lens group 4, then reflected by the first reflective mirror 5 and the first dichroscope 6, then incident into the first objective lens 18 in the form of parallel light and finally is focused onto the surface of the sample carried by the mobile station 19.

Preferably, the first light source 1 is a continuous laser light source or a pulse laser light source. More preferably, a wavelength adjustment range is 157nm-1064nm; more preferably, a polarization state of the light source is linear polarization, circular polarization or elliptical polarization; and more preferably, the frequency of the pulse laser light source is 1Hz-100MHz.

Preferably, the first light beam expanding lens group 4 may be realized through combination of lenses, such as combination of two convex lenses or combination of one concave lens and one convex lens. Light beam expanding magnification of the first light beam expanding lens group 4 may be within a range of 0.1-100.

Preferably, the first objective lens 18 is a dry objective lens, a water immersion objective lens or an oil immersion objective lens. Still preferably, a numerical aperture is 0.001-1.8 and magnification is 1-200.

Preferably, the laser point-by-point scanning exposure unit further comprises: a first light gate 3 provided between the first light source 1 and the first light beam expanding lens group 4 and used for adjusting exposure time of the laser point-by-point scanning exposure unit under the control of the calculation and control unit 20. More preferably, the first light gate is a mechanical shutter or a light modulator.

Preferably, the laser point-by-point scanning exposure unit further comprises: a first energy control assembly 2 provided between the first light source and the first light gate and used for adjusting energy or power of the light emitted by the first light source. More preferably, the first energy control assembly 2 is a light absorbing type optical attenuator, a polarizer, a half-wave plate or an acousto-optic modulator.

Preferably, the laser point-by-point scanning exposure unit further comprises: a two-dimensional galvanometer provided between the first reflective mirror and the first dichroscope. With the two-dimensional galvanometer, the mobile station can achieve the purpose of point-by-point scanning exposure through one-dimensional movement only, and the working efficiency is improved. In the plane projection exposure unit, the light emitted by the second light source 7 sequentially passes through the second light beam expanding lens group 10, becomes incident onto the spatial light modulator 15 and passes through the spatial light modulator 15, and the emergent light has a plane pattern corresponding to the pattern portion with the required precision greater than the predetermined threshold; the light beam then passes through the second lens 16, the second dichroscope 17 and the first dichroscope 6 and then enters into the first objective lens 18, wherein after the light beam passes through the lens 16, each light beam and the entire plane light source converge at a front focal plane of the objective lens, and each light beam and the entire plane light source, after passing through the first objective lens 18, become parallel light which is projected onto the surface of the sample carried by the three-dimensional mobile station; and the calculation and control unit controls the change of the spatial light modulator 15 and the movement of the mobile station 19 to realize the cooperative operation of the two scanning units.

Preferably, the second light source 7 is a continuous laser light source or a pulse laser light source; more preferably, a wavelength adjustment range is 157nm-1064nm; a polarization state may be linear polarization, circular polarization or elliptical polarization; the frequency of the pulse laser light source is 1Hz-100MHz; alternatively, the second light source 7 is a mercury lamp, a xenon lamp, a bromine-tungsten lamp or an LED lamp; and more preferably, a wavelength range is 157nm-1064nm.

Preferably, the second light beam expanding lens group 10 may be realized through combination of lenses, such as combination of two convex lenses or combination of one concave lens and one convex lens. Light beam expanding magnification of the second light beam expanding lens group 10 may be within a range of 0.1-100.

Preferably, the spatial light modulation device 15 is a spatial light modulator for performing light amplitude modulation to the light, a spatial light modulator for performing light phase modulation to the light or a spatial light modulator for performing polarization modulation to the light.

Preferably, the focal length of the second lens 16 is within a range of 1mm-500mm.

Preferably, the plane projection exposure unit further comprises: a second light gate 9 provided between the second light source 7 and the second light beam expanding lens group 10 and used for adjusting exposure time of the plane projection exposure unit under the control of the calculation and control unit 20. More preferably, the second light gate 9 is a mechanical shutter or a light modulator.

Preferably, the plane projection exposure unit further comprises: a second energy control assembly 8 provided between the second light source 7 and the second light gate 9 and used for adjusting energy or power of the light emitted by the second light source 7. More preferably, the second energy control assembly 8 is a light absorbing type optical attenuator, a polarizer, a half-wave plate or an acousto-optic modulator.

Preferably, the plane projection exposure unit further comprises a light beam homogenizing assembly 11 and the light beam homogenizing assembly 11 homogenizes the parallel light formed after light beam expansion performed by the second light beam expanding lens group 10.

When the second light source 7 is laser, the light beam homogenizing assembly 11 may be realized through combination of lenses capable of changing laser to flattened light, such as combination of Kepler or Galileo lenses; and when the second light source 7 is a lamp source such as a mercury lamp, the light beam homogenizing assembly 11 may be realized through a fly lens group, etc.

Preferably, the plane projection exposure unit further comprises a diaphragm 12 for restricting emergence area of the homogenized light.

Preferably, the plane projection exposure unit further comprises a second reflective mirror 13 and a third reflective mirror 14, wherein the light emergent from the diaphragm 12 is guided into the spatial light modulation device 15 sequentially through the second reflective mirror 13 and the third reflective mirror 14.

In one specific example, the calculation and control unit 20 comprises: a data reading part for reading the pattern to be exposed; a data processing part for decomposing the pattern to be exposed; and a control part for controlling the mobile station, the laser point-by-point scanning exposure unit and the plane projection exposure unit to work cooperatively.

In one specific example, the mobile station 19 is selected from the following group consisting of a three-dimensional mobile station consisting of three independent linearly-moving mobile stations; a three-dimensional mobile station consisting of a two-dimensional parallel-connection mobile station and one independent mobile station; a three-dimensional parallel-connection mobile station; or a multidimensional mobile station consisting of mobile stations with rotating and tilting functions, wherein a movement range is preferably 1nm-10000mm and more preferably 0.1µm-1m, a rotation angle is 0-360° and a tilt angle is -90°-+90°.

FIG. 2 illustrates a schematic diagram of a maskless photolithographic system in cooperatively working mode for a cross-scale structure which does not form part of the present invention. In this system, except the laser point-by-point scanning exposure unit and the plane projection exposure unit respectively use respective objective lens 18 and objective lens 21, other structures in the system are the same as that in the system illustrated in FIG. 1.

The purpose of the maskless photolithographic system in cooperatively working mode for a cross-scale structure provided by the present invention is to realize a method for exposing a cross-scale structure in one exposure process. Steps are as follows:
1) The first light source and the second light source are turned on.
2) The light emitted by the first light source, after beam expansion, being adjusted by the reflective mirror and the dichroscope, is focused onto the focal plane of the objective lens.
3) The light beam emitted by the second light source forms a plane pattern after being modulated by the spatial light modulator and further forms an image on the focal plane of the objective lens through an imaging lens consisting of the lens and the objective lens.
4) Calibrated is a displacement difference between coordinates of a central point of plane projection exposure and coordinates of a focal point of laser point-by-point scanning.
5) The graph document (as illustrated in FIG. 3) is input and pattern data are decomposed. The pattern portion with the required precision below the predetermined threshold (such as the portion illustrated in FIG. 4 after FIG. 3 is decomposed) is allocated to the laser point-by-point scanning exposure unit, and the calculation and control unit controls the mobile station to move according to data of this portion. The pattern portion with the required precision above 1µm (e.g., the portion illustrated in FIG. 5 after FIG. 3 is decomposed) is allocated to the plane projection exposure unit, and the calculation and control unit allocates pattern data of this portion to the spatial light modulator to enable a plane light source to emit light corresponding to the model data.
6) Plane projection exposure and laser point-by-point scanning exposure are sequentially performed, and when switching from each other, the mobile station is moved for the displacement difference in step 4) so as to accurately splice the two exposed patterns. The deflection between the coordinates of the central point of plane projection exposure and the coordinates of the focal point of laser point-by-point exposure in the two exposed patterns caused by the optical structures is compensated by moving the mobile station for fixed displacement.
7) The photosensitive material is disposed on the sample table of the mobile station controlled by the calculation and control unit, and the exposure time is controlled through the light gates, and the transmissivity of the laser energy or the plane projection exposure energy is controlled through the energy control assemblies.
8) A structure is obtained through post-processing processes: the photosensitive material obtained in step 6) under the cooperative working of laser point-by-point scanning and plane projection exposure is subjected to processes such as washing, heating decomposition, ablation, etching and development, and corresponding process conditions are selected according to the type of the material; and the portion of the photosensitive material which does not interact with light is removed to obtain a negative structure, or the portion of the photosensitive material which interacts with light is removed to obtain a positive structure.

In the above-mentioned technical solution, the photosensitive material may be an organic photosensitive material, an inorganic photosensitive material or a photosensitive material containing metal ions.

The present invention will be described below in detail in combination with specific examples. The purposes and effects of the present invention will become more obvious.

Embodiment 1: two-dimensional structure realized through plane projection exposure A 370nm femto-second titanium sapphire light source was used as a plane projection exposure light source, with the pulse width being 100fs, the pulse repetition frequency being 82MHz, the diameter of a light beam being 2mm. The laser light was expanded by a light beam expanding lens group to form a parallel light beam with diameter of 50mm. A rectangular uniform light spot in a central range of 10mm^{∗}14mm was obtained through a light beam interception method and became incident onto a DMD surface from an angle of 24°. Then, the light beam reflected by the DMD surface was finally projected onto a surface of a photosensitive material (I-PL) through a convex lens with focal length of 250mm and a 50X objective lens (with a numerical aperture of 0.8). A light gate controls the exposure time to be 300ms. Finally, a pattern realized through plane projection exposure was as illustrated in FIG. 6, and a plane projection exposure range was 179µm^{∗}237.9µm.

Embodiment 2: two-dimensional structure realized through laser point-by-point scanning exposure

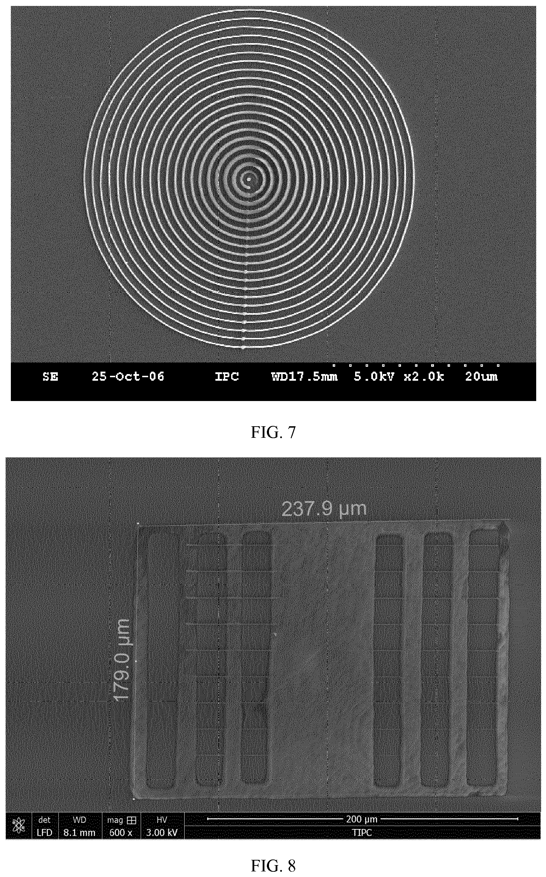

A 800nm femto-second titanium sapphire light source was used as a laser point-by-point scanning exposure light source, with the pulse width being 100fs, the pulse repetition frequency being 82MHz, the diameter of a light beam being 1.8mm. The laser light was expanded through a light beam expanding lens group to form a parallel light beam with diameter of 10mm. The parallel light beam was focused onto a surface of a photosensitive material (SCR500) through an objective lens wherein the objective lens was an oil immersion objective lens with a numerical aperture 1.4 and magnification of 100. Concentric circles obtained through the point-by-point scanning method were as illustrated in FIG. 7, and the processing resolution was 120nm.

Embodiment 3: cross-scale two-dimensional structure manufactured through plane projection and laser point-by-point scanning cooperative exposure

A 370nm femto-second titanium sapphire light source was used as a plane projection exposure light source, with the pulse width being 100fs, the pulse repetition frequency being 82MHz, the diameter of a light beam being 2mm.The laser light was expanded by a light beam expanding lens group to form a parallel light beam with diameter of 50mm. A rectangular uniform light spot in a central range of 10mm^{∗}14mm was obtained through a light beam interception method and became incident onto a DMD surface from an angle of 24°. Then, the light beam reflected by the DMD surface was finally projected onto a surface of a photosensitive material (I-PL) through a convex lens with focal length of 250mm and an objective lens. A light gate controls the exposure time to be 300ms. Simultaneously, a 740nm femto-second titanium sapphire light source was used as a laser point-by-point scanning exposure light source, with the pulse width being 100fs, the pulse repetition frequency being 82MHz, the diameter of a light beam being 1.8mm. The laser light was expanded through a light beam expanding lens group to form a parallel light beam with diameter of 10mm. The parallel light beam was focused onto a surface of a photosensitive material (I-PL) through an objective lens. In this example, plane projection exposure and laser point-by-point scanning exposure shared the same objective lens with a numerical aperture of the objective lens being 0.8. The objective lens was a dry objective lens with magnification of 50 (namely, 50X). The structure realized through cooperative exposure was as illustrated in FIG. 8, and a plane projection exposure range was 179µm^{∗}237.9µm.

## Claims

1. A maskless photolithographic system in cooperative working mode for cross-scale structures, comprising:
a laser point-by-point scanning exposure unit, a plane projection exposure unit, a mobile station (19), and a calculation and control unit (20);
wherein the calculation and control unit (20) decomposes a pattern to be exposed, such that a pattern portion with a required precision below a predetermined threshold is exposed by the laser point-by-point scanning exposure unit, and the pattern portion with a required precision above the predetermined threshold is exposed by the plane projection exposure unit;
when laser point-by-point scanning exposure is performed to a sample on the mobile station (19), light emergent from the laser point-by-point scanning exposure unit moves relative to the sample according to the pattern portion with the required precision below the predetermined threshold, so as to realize the laser point-by-point scanning exposure to the sample; and
when plane projection exposure is performed to the sample, the plane projection exposure unit enables light with a shape corresponding to the pattern portion to become emergent onto the sample according to the pattern portion with the required precision above the predetermined threshold, so as to realize the plane projection exposure to the sample;
wherein the laser point-by-point scanning exposure unit comprises:
a first light source (1), a first light beam expanding lens group (4), a first light transmission direction adjustment optical assembly (5, 6), and a first objective lens (18);
wherein the first light source emits (1) light for laser point-by-point scanning; the first light beam expanding lens group (4) expands the light emitted by the first light source (1) to form parallel light;
the first light transmission direction adjustment optical assembly (5, 6) guides the parallel light formed after light beam expansion performed by the first light beam expanding lens group (4) into the first objective lens (18); and
the first objective lens (18) focuses the guided-in light onto the sample, wherein optionally magnification of the first objective lens is 1-200 and a numerical aperture is 0.001-1.8; and
wherein the plane projection exposure unit comprises:
a second light source (7), a second light beam expanding lens group (10), a spatial light modulation device (15), a second light transmission direction adjustment optical assembly (16, 17, 6), and the first objective lens (18);
wherein the second light source (7) emits light for plane projection exposure photolithography;
the second light beam expanding lens group (10) expands the light emitted by the second light source (7) to form parallel light;
according to the pattern portion with the required precision above the predetermined threshold provided by the calculation and control unit (20), the spatial light modulation device (15) modulates the parallel light formed after light beam expansion performed by the second light beam expanding lens group (10) to form parallel light with the shape corresponding to the pattern portion and enables the parallel light to become emergent to the second light transmission direction adjustment optical assembly (16, 17, 6);
the second light transmission direction adjustment optical assembly (16, 17, 6) focuses the parallel light with the shape corresponding to the pattern portion onto a front focal plane of the first objective lens (18); and
the first objective lens (18) projects the parallel light onto the sample.

2. The photolithographic system according to claim 1, wherein the laser point-by-point scanning exposure unit further comprises:
a first light gate (3) provided between the first light source (1) and the first light beam expanding lens group (4) adjusting exposure time of the laser point-by-point scanning exposure unit under the control of the calculation and control unit (20),
wherein the first light gate (3) is optionally a first mechanical shutter or a first light modulator.

3. The photolithographic system according to claim 2, wherein the laser point-by-point scanning exposure unit further comprises:
a first energy control assembly (2) provided between the first light source (1) and the first light gate (3) adjusting energy or power of the light emitted by the first light source (1),
wherein the first energy control assembly (2) is optionally a light absorbing type optical attenuator, a polarizer, a half-wave plate or an acousto-optic modulator.

4. The photolithographic system according to claim 1, wherein the first light transmission direction adjustment optical assembly comprises:
a first reflective mirror (5) and a first dichroscope (6), wherein the parallel light formed after light beam expansion performed by the first light beam expanding lens group (4) is guided into the first objective lens (18) sequentially through the first reflective mirror (5) and the first dichroscope (6), and
wherein the laser point-by-point scanning exposure unit optionally further comprises: a two-dimensional galvanometer provided between the first reflective mirror (5) and the first dichroscope (6).

5. The photolithographic system according to claim 1, wherein the first light source (1) is a continuous laser light source or a pulse laser light source with a wavelength adjustment range of 157nm-1064nm and a polarization state being linear polarization, circular polarization or elliptical polarization, and
wherein the frequency of the pulse laser light source is 1Hz-100MHz.

6. The photolithographic system according to claim 1, wherein the plane projection exposure unit further comprises:
a second light gate (9) provided between the second light source (7) and the second light beam expanding lens group (10) adjusting exposure time of the plane projection exposure unit under the control of the calculation and control unit (20),
wherein the second light gate (9) is optionally a second mechanical shutter or a second light modulator.

7. The photolithographic system according to claim 6, wherein the plane projection exposure unit further comprises:
a second energy control assembly (8) provided between the second light source (7) and the second light gate (9) adjusting energy or power of the light emitted by the second light source (7),
wherein the second energy control assembly (8) is optionally a light absorbing type optical attenuator, a polarizer, a half-wave plate or an acousto-optic modulator.

8. The photolithographic system according to claim 4, wherein the second light transmission direction adjustment optical assembly comprises:
a second lens (16), a second dichroscope (17) and the first dichroscope (6), wherein the parallel light with the shape corresponding to the pattern portion is focused onto the front focal plane of the first objective lens (18) sequentially through the second lens (16), the second dichroscope (17) and the first dichroscope (6).

9. The photolithographic system according to claim 1, wherein the plane projection exposure unit further comprises:
a light beam homogenizing assembly (11) which homogenizes the parallel light formed after light beam expansion performed by the second light beam expanding lens group (10),
wherein the plane projection exposure unit optionally further comprises a diaphragm (12) restricting emergence area of the homogenized light, a second reflective mirror (13) and a third reflective mirror (14), wherein the light emergent from the diaphragm (12) is guided into the spatial light modulation device (15) sequentially through the second reflective mirror (13) and the third reflective mirror (14).

10. The photolithographic system according to claim 1, wherein the second light source (7) is selected from the group consisting of:
a continuous laser light source or a pulse laser light source with a wavelength adjustment range of 157nm-1064nm and a polarization state being linear polarization, circular polarization or elliptical polarization, wherein the frequency of the pulse laser light source is 1Hz-100MHz; or
a mercury lamp, a xenon lamp, a bromine-tungsten lamp or an LED lamp with a wavelength range of 157nm-1064nm.

11. The photolithographic system according to claim 1, wherein the spatial light modulation device (15) is a spatial light modulator performing light amplitude modulation to the light, a spatial light modulator performing light phase modulation to the light or a spatial light modulator performing polarization modulation to the light.

12. The photolithographic system according to claim 1, wherein the mobile station (19) is selected from the group consisting of:
a three-dimensional mobile station consisting of three independent linearly-moving mobile stations;
a three-dimensional mobile station consisting of a two-dimensional parallel-connection mobile station and one independent mobile station;
a three-dimensional parallel-connection mobile station; or
a multidimensional mobile station consisting of mobile stations with rotating and tilting functions,
wherein a movement range is 0.1µm-1m, a rotation angle is 0-360° and a tilt angle is -90°-+90°.

13. The photolithographic system according to claim 1, wherein the calculation and control unit (20) comprises:
a data reading part reading the pattern to be exposed;
a data processing part decomposing the pattern to be exposed; and
a control part controlling the mobile station (19), the laser point-by-point scanning exposure unit and the plane projection exposure unit to work cooperatively.

## Patentansprüche

1. Maskenloses photolithographisches System im kooperativen Arbeitsmodus für skalenübergreifende Strukturen, umfassend:
eine Belichtungseinheit mit punktweiser Laserabtastung, eine Ebenenprojektionsbelichtungseinheit, eine Mobilstation (19) und eine Berechnungs- und Steuereinheit (20);
wobei die Berechnungs- und Steuereinheit (20) eine zu belichtende Struktur derart zergliedert, dass ein Strukturabschnitt mit einer erforderlichen Präzision unterhalb einer vorbestimmten Schwelle durch die Belichtungseinheit mit punktweiser Laserabtastung belichtet wird und der Strukturabschnitt mit einer erforderlichen Präzision oberhalb der vorbestimmten Schwelle durch die Ebenenprojektionsbelichtungseinheit belichtet wird;
wenn eine Laserbelichtung mit punktweiserAbtastung an einem Probestück auf der Mobilstation (19) durchgeführt wird, sich aus der Belichtungseinheit mit punktweiser Laserabtastung austretendes Licht gemäß dem Strukturabschnitt mit der erforderlichen Präzision unterhalb der vorbestimmten Schwelle relativ zu dem Probestück bewegt, um die Laserbelichtung mit punktweiser Abtastung an dem Probestück zu realisieren; und
wenn eine Ebenenprojektionsbelichtung an dem Probestück durchgeführt wird, die Ebenenprojektionsbelichtungseinheit Licht mit einer dem Strukturabschnitt entsprechenden Form so freigibt, dass es gemäß dem Strukturabschnitt mit der erforderlichen Präzision oberhalb der vorbestimmten Schwelle auf das Probestück austritt, um die Ebenenprojektionsbelichtung an dem Probestück zu realisieren;
wobei die Belichtungseinheit mit punktweiser Laserabtastung umfasst:
eine erste Lichtquelle (1), eine erste Lichtstrahlausbreitungslinsengruppe (4), eine erste optische Anordnung (5, 6) zur Lichttransmissionsrichtungsanpassung und eine erste Objektivlinse (18);
wobei die erste Lichtquelle (1) Licht für eine punktweise Laserabtastung emittiert;
die erste Lichtstrahlausbreitungslinsengruppe (4) das durch die erste Lichtquelle (1) emittierte Licht ausbreitet, um Parallellicht zu bilden;
die erste optische Anordnung (5, 6) zur Lichttransmissionsrichtungsanpassung das Parallellicht, das nach der durch die Lichtstrahlausbreitungslinsengruppe (4) durchgeführten Lichtstrahlausbreitung gebildet wird, in die erste Objektivlinse (18) leitet; und
die erste Objektivlinse (18) das eingeleitete Licht auf das Probestück fokussiert,
wobei optional eine Vergrößerung der ersten Objektivlinse 1-200 beträgt und eine numerische Apertur 0,001-1,8 beträgt; und
wobei die Ebenenprojektionsbelichtungseinheit umfasst:
eine zweite Lichtquelle (7), eine zweite Lichtstrahlausbreitungslinsengruppe (10), eine räumliche Lichtmodulationsvorrichtung (15), eine zweite optische Anordnung (16, 17, 6) zur Lichttransmissionsrichtungsanpassung und die erste Objektivlinse (18);
wobei die zweite Lichtquelle (7) Licht für eine Ebenenprojektionsbelichtung-Photolithographie emittiert;
die zweite Lichtstrahlausbreitungslinsengruppe (10) das durch die zweite Lichtquelle (7) emittierte Licht ausbreitet, um Parallellicht zu bilden;
gemäß dem Strukturabschnitt mit der erforderlichen Präzision oberhalb der vorbestimmten Schwelle, die durch die Berechnungs- und Steuereinheit (20) bereitgestellt wird, die räumliche Lichtmodulationsvorrichtung (15) das nach der durch die zweite Lichtstrahlausbreitungslinsengruppe (10) durchgeführten Lichtstrahlausbreitung gebildete Parallellicht moduliert, um Parallellicht mit der dem Strukturabschnitt entsprechenden Form zu bilden, und das Parallellicht so freigibt, dass es auf die zweite optische Anordnung (16, 17, 6) zur Lichttransmissionsrichtungsanpassung austritt;
die zweite optische Anordnung (16, 17, 6) zur Lichttransmissionsrichtungsanpassung das Parallellicht mit der dem Strukturabschnitt entsprechenden Form auf eine vordere Fokalebene der ersten Objektivlinse (18) fokussiert; und
die erste Objektivlinse (18) das Parallellicht auf das Probestück projiziert.

2. Photolithographisches System nach Anspruch 1, wobei die Belichtungseinheit mit punktweiser Laserabtastung weiter umfasst:
ein erstes Lichtgatter (3), das zwischen der ersten Lichtquelle (1) und der ersten Lichtstrahlausbreitungslinsengruppe (4) bereitgestellt ist und eine Belichtungszeit der Belichtungseinheit mit punktweiser Laserabtastung unter der Steuerung der Berechnungs- und Steuereinheit (20) einstellt,
wobei das erste Lichtgatter (3) optional ein erster mechanischer Verschluss oder ein erster Lichtmodulator ist.

3. Photolithographisches System nach Anspruch 2, wobei die Belichtungseinheit mit punktweiser Laserabtastung weiter umfasst:
eine erste Energiesteueranordnung (2), die zwischen der ersten Lichtquelle (1) und dem ersten Lichtgatter (3) bereitgestellt ist und eine Energie oder Leistung des durch die erste Lichtquelle (1) emittierten Lichts einstellt,
wobei die erste Energiesteueranordnung (2) optional ein optischer Dämpfer des Licht absorbierenden Typs, ein Polarisator, ein λ/2-Plättchen oder ein akustooptischer Modulator ist.

4. Photolithographisches System nach Anspruch 1, wobei die erste optische Anordnung zur Lichttransmissionsrichtungsanpassung umfasst:
einen ersten Reflexionsspiegel (5) und ein erstes Dichroskop (6), wobei das nach der durch die erste Lichtstrahlausbreitungslinsengruppe (4) durchgeführten Lichtstrahlausbreitung gebildete Parallellicht nacheinander durch den ersten Reflexionsspiegel (5) und das erste Dichroskop (6) in die erste Objektivlinse (18) geleitet wird, und
wobei die Belichtungseinheit mit punktweiser Laserabtastung optional weiter umfasst: ein zweidimensionales Galvanometer, das zwischen dem ersten Reflexionsspiegel (5) und dem ersten Dichroskop (6) bereitgestellt ist.

5. Photolithographisches System nach Anspruch 1, wobei die erste Lichtquelle (1) eine kontinuierliche Laserlichtquelle oder eine Impulslaserlichtquelle mit einem Wellenlängeneinstellbereich von 157nm-1064nm und einem Polarisationszustand, bei dem es sich um eine lineare Polarisation, eine Zirkularpolarisation oder eine elliptische Polarisation handelt, ist, und
wobei die Frequenz der Impulslaserlichtquelle 1Hz-100MHz beträgt.

6. Photolithographisches System nach Anspruch 1, wobei die Ebenenprojektionsbelichtungseinheit weiter umfasst:
ein zweites Lichtgatter (9), das zwischen der zweiten Lichtquelle (7) und der zweiten Lichtstrahlausbreitungslinsengruppe (10) bereitgestellt ist und eine Belichtungszeit der Ebenenprojektionsbelichtungseinheit unter der Steuerung der Berechnungs- und Steuereinheit (20) einstellt,
wobei das zweite Lichtgatter (9) optional ein zweiter mechanischer Verschluss oder ein zweiter Lichtmodulator ist.

7. Photolithographisches System nach Anspruch 6, wobei die Ebenenprojektionsbelichtungseinheit weiter umfasst:
eine zweite Energiesteueranordnung (8), die zwischen der zweiten Lichtquelle (7) und dem zweiten Lichtgatter (9) angeordnet ist und eine Energie oder Leistung des durch die zweite Lichtquelle (7) emittierten Lichts einstellt,
wobei die zweite Energiesteueranordnung (8) optional ein optischer Dämpfer vom Licht absorbierenden Typ, ein Polarisator, ein λ/2-Plättchen oder ein akustooptischer Modulator ist.

8. Photolithographisches System nach Anspruch 4, wobei die zweite optische Anordnung zur Lichttransmissionsrichtungsanpassung umfasst:
eine zweite Linse (16), ein zweites Dichroskop (17) und das erste Dichroskop (6), wobei das Parallellicht mit der dem Strukturabschnitt entsprechenden Form nacheinander durch die zweite Linse (16), das zweite Dichroskop (17) und das erste Dichroskop (6) auf die vordere Fokalebene der ersten Objektivlinse (18) fokussiert wird.

9. Photolithographisches System nach Anspruch 1, wobei die Ebenenprojektionsbelichtungseinheit weiter umfasst:
eine Lichtstrahlhomogenisierungsanordnung (11), die das nach der durch die zweite Lichtstrahlausbreitungslinsengruppe (10) durchgeführten Lichtstrahlausbreitung gebildete Parallellicht homogenisiert,
wobei die Ebenenprojektionsbelichtungseinheit optional weiter eine Blende (12), die einen Austrittsbereich des homogenisierten Lichts beschränkt, einen zweiten Reflexionsspiegel (13) und einen dritten Reflexionsspiegel (14) umfasst, wobei das aus der Blende (12) austretende Licht nacheinander durch den zweiten Reflexionsspiegel (13) und den dritten Reflexionsspiegel (14) in die räumliche Lichtmodulationsvorrichtung (15) geleitet wird.

10. Photolithographisches System nach Anspruch 1, wobei die zweite Lichtquelle (7) aus der Gruppe ausgewählt ist, die aus Folgenden besteht:
einer kontinuierlichen Laserlichtquelle oder einer Impulslaserlichtquelle mit einem Wellenlängeneinstellbereich von 157nm-1064nm und einem Polarisationszustand, bei dem es sich um eine lineare Polarisation, eine Zirkularpolarisation oder eine elliptische Polarisation handelt, wobei die Frequenz der Impulslaserlichtquelle 1Hz-100MHz beträgt;
oder
einer Quecksilberlampe, einer Xenonlampe, einer Brom-Wolfram-Lampe oder einer LED-Lampe mit einem Wellenlängenbereich von 157nm-1064nm.

11. Photolithographisches System nach Anspruch 1, wobei die räumliche Lichtmodulationsvorrichtung (15) ein räumlicher Lichtmodulator, der eine Lichtamplitudenmodulation an dem Licht durchführt, ein räumlicher Lichtmodulator, der eine Lichtphasenmodulation an dem Licht durchführt, oder ein räumlicher Lichtmodulator, der eine Polarisationsmodulation an dem Licht durchführt, ist.

12. Photolithographisches System nach Anspruch 1, wobei die Mobilstation (19) aus der Gruppe ausgewählt ist, die aus Folgenden besteht:
einer dreidimensionalen Mobilstation, die aus drei unabhängigen sich linear bewegenden Mobilstationen besteht;
einer dreidimensionalen Mobilstation, die aus einer zweidimensionalen Parallelschaltungsmobilstation und einer unabhängigen Mobilstation besteht;
einer dreidimensionalen Parallelschaltungsmobilstation; oder
einer mehrdimensionalen Mobilstation, die aus Mobilstationen mit Dreh- und Kippfunktionen besteht,
wobei ein Bewegungsbereich 0,1µm-1m beträgt, ein Drehwinkel 0-360° beträgt und ein Kippwinkel -90°-+90° beträgt.

13. Photolithographisches System nach Anspruch 1, wobei die Berechnungs- und Steuereinheit (20) umfasst:
einen Datenleseteil, der die zu belichtende Struktur einliest;
einen Datenverarbeitungsteil, der die zu belichtende Struktur zergliedert; und
einen Steuerteil, der die Mobilstation (19), die Belichtungseinheit mit punktweiser Laserabtastung und die Ebenenprojektionsbelichtungseinheit dahingehend steuert, dass sie kooperativ arbeiten.

## Revendications

1. Système photolithographique sans masque en mode de fonctionnement coopératif pour des structures inter-échelle, comprenant :
une unité d'exposition par balayage laser point par point, une unité d'exposition par projection plane, une station mobile (19), et une unité de calcul et de commande (20) ;
dans lequel l'unité de calcul et de commande (20) décompose un motif devant être exposé, de telle sorte qu'une portion de motif avec une précision exigée inférieure à un seuil prédéterminé soit exposée par l'unité d'exposition par balayage laser point par point, et la portion de motif avec une précision exigée supérieure au seuil prédéterminé soit exposée par l'unité d'exposition par projection plane ;
lorsqu'une exposition par balayage laser point par point est effectuée sur un échantillon sur la station mobile (19), une lumière émergeant de l'unité d'exposition par balayage laser point par point se déplace par rapport à l'échantillon selon la portion de motif avec la précision exigée inférieure au seuil prédéterminé, de façon à réaliser l'exposition par balayage laser point par point sur l'échantillon ; et
lorsqu'une exposition par projection plane est effectuée sur l'échantillon, l'unité d'exposition par projection plane permet à une lumière avec une forme correspondant à la portion de motif de devenir émergente sur l'échantillon selon la portion de motif avec la précision exigée supérieure au seuil prédéterminé, de façon à réaliser l'exposition par projection plane sur l'échantillon ;
dans lequel l'unité d'exposition par balayage laser point par point comprend :
une première source de lumière (1), un premier groupe de lentilles d'élargissement de faisceau lumineux (4), un premier ensemble optique d'ajustement de direction de transmission de lumière (5, 6), et un premier objectif (18) ;
dans lequel la première source de lumière (1) émet une lumière pour un balayage laser point par point ;
le premier groupe de lentilles d'élargissement de faisceau lumineux (4) élargit la lumière émise par la première source de lumière (1) pour former une lumière parallèle ;
le premier ensemble optique d'ajustement de direction de transmission de lumière (5, 6) guide la lumière parallèle formée après un élargissement de faisceau lumineux effectué par le premier groupe de lentilles d'élargissement de faisceau lumineux (4) dans le premier objectif (18) ; et
le premier objectif (18) concentre la lumière guidée à l'intérieur sur l'échantillon,
dans lequel optionnellement un grossissement du premier objectif est de 1 à 200 et une ouverture numérique est de 0,001 à 1,8 ; et
dans lequel l'unité d'exposition par projection plane comprend :
une seconde source de lumière (7), un second groupe de lentilles d'élargissement de faisceau lumineux (10), un dispositif de modulation spatiale de lumière (15), un second ensemble optique d'ajustement de direction de transmission de lumière (16, 17, 6), et le premier objectif (18) ;
dans lequel la seconde source de lumière (7) émet une lumière pour une photolithographie à exposition par projection plane ;
le second groupe de lentilles d'élargissement de faisceau lumineux (10) élargit la lumière émise par la seconde source de lumière (7) pour former une lumière parallèle ;
selon la portion de motif avec la précision exigée supérieure au seuil prédéterminé fournie par l'unité de calcul et de commande (20), le dispositif de modulation spatiale de lumière (15) module la lumière parallèle formée après un élargissement de faisceau lumineux effectué par le second groupe de lentilles d'élargissement de faisceau lumineux (10) pour former une lumière parallèle avec la forme correspondant à la portion de motif et permet à la lumière parallèle de devenir émergente vers le second ensemble optique d'ajustement de direction de transmission de lumière (16, 17, 6) ;
le second ensemble optique d'ajustement de direction de transmission de lumière (16, 17, 6) concentre la lumière parallèle avec la forme correspondant à la portion de motif sur un plan focal avant du premier objectif (18) ; et
le premier objectif (18) projette la lumière parallèle sur l'échantillon.

2. Système photolithographique selon la revendication 1, dans lequel l'unité d'exposition par balayage laser point par point comprend en outre :
un cache de lumière (3) fourni entre la première source de lumière (1) et le premier groupe de lentilles d'élargissement de faisceau lumineux (4) ajustant un temps d'exposition de l'unité d'exposition par balayage laser point par point sous la commande de l'unité de calcul et de commande (20),
dans lequel le premier cache de lumière (3) est optionnellement un premier obturateur mécanique ou un premier modulateur de lumière.

3. Système photolithographique selon la revendication 2, dans lequel l'unité d'exposition par balayage laser point par point comprend en outre :
un premier ensemble de commande d'énergie (2) fourni entre la première source de lumière (1) et le premier cache de lumière (3) ajustant une énergie ou une puissance de la lumière émise par la première source de lumière (1),
dans lequel le premier ensemble de commande d'énergie (2) est optionnellement un atténuateur optique du type à absorption de lumière, un polariseur, une lame demi-onde ou un modulateur acousto-optique.

4. Système photolithographique selon la revendication 1, dans lequel le premier ensemble optique d'ajustement de direction de transmission de lumière comprend :
un premier miroir réfléchissant (5) et un premier dichroscope (6), dans lequel la lumière parallèle formée après un élargissement de faisceau lumineux effectué par le premier groupe de lentilles d'élargissement de faisceau lumineux (4) est guidée dans le premier objectif (18) de manière séquentielle par l'intermédiaire du premier miroir réfléchissant (5) et du premier dichroscope (6), et
dans lequel l'unité d'exposition par balayage laser point par point comprend optionnellement en outre :
un galvanomètre bidimensionnel fourni entre le premier miroir réfléchissant (5) et le premier dichroscope (6).

5. Système photolithographique selon la revendication 1, dans lequel la première source de lumière (1) est une source de lumière laser continue ou une source de lumière laser à impulsions avec une plage d'ajustement de longueurs d'onde de 157 nm à 1 064 nm et un état de polarisation qui est une polarisation linéaire, une polarisation circulaire ou une polarisation elliptique, et
dans lequel la fréquence de la source de lumière laser à impulsions est de 1 Hz à 100 MHz.

6. Système photolithographique selon la revendication 1, dans lequel l'unité d'exposition par projection plane comprend en outre :
un second cache de lumière (9) fourni entre la seconde source de lumière (7) et le second groupe de lentilles d'élargissement de faisceau lumineux (10) ajustant un temps d'exposition de l'unité d'exposition par projection plane sous la commande de l'unité de calcul et de commande (20),
dans lequel le second cache de lumière (9) est optionnellement un second obturateur mécanique ou un second modulateur de lumière.

7. Système photolithographique selon la revendication 6, dans lequel l'unité d'exposition par projection plane comprend en outre :
un second ensemble de commande d'énergie (8) fourni entre la seconde source de lumière (7) et le second cache de lumière (9) ajustant une énergie ou une puissance de la lumière émise par la seconde source de lumière (7),
dans lequel le second ensemble de commande d'énergie (8) est optionnellement un atténuateur optique du type à absorption de lumière, un polariseur, une lame demi-onde ou un modulateur acousto-optique.

8. Système photolithographique selon la revendication 4, dans lequel le second ensemble optique d'ajustement de direction de transmission de lumière comprend :
une seconde lentille (16), un second dichroscope (17) et le premier dichroscope (6), dans lequel la lumière parallèle avec la forme correspondant à la portion de motif est concentrée sur le plan focal avant du premier objectif (18) de manière séquentielle par l'intermédiaire de la seconde lentille (16), du second dichroscope (17) et du premier dichroscope (6).

9. Système photolithographique selon la revendication 1, dans lequel l'unité d'exposition par projection plane comprend en outre :
un ensemble d'homogénéisation de faisceau lumineux (11) qui homogénéise la lumière parallèle formée après un élargissement de faisceau lumineux effectué par le second groupe de lentilles d'élargissement de faisceau lumineux (10),
dans lequel l'unité d'exposition par projection plane comprend optionnellement en outre un diaphragme (12) limitant une superficie d'émergence de la lumière homogénéisée, un deuxième miroir réfléchissant (13) et un troisième miroir réfléchissant (14), dans lequel la lumière émergeant du diaphragme (12) est guidée dans le dispositif de modulation spatiale de lumière (15) de manière séquentielle par l'intermédiaire du deuxième miroir réfléchissant (13) et du troisième miroir réfléchissant (14).

10. Système photolithographique selon la revendication 1, dans lequel la seconde source de lumière (7) est sélectionnée dans le groupe consistant en :
une source de lumière laser continue ou une source de lumière laser à impulsions avec une plage d'ajustement de longueurs d'onde de 157 nm à 1 064 nm et un état de polarisation qui est une polarisation linéaire, une polarisation circulaire ou une polarisation elliptique, dans lequel la fréquence de la source de lumière laser à impulsions est de 1 Hz à 100 MHz ; ou
une lampe à mercure, une lampe au xénon, une lampe au brome-tungstène ou une lampe à LED avec une plage de longueurs d'onde de 157 nm à 1 064 nm.

11. Système photolithographique selon la revendication 1, dans lequel le dispositif de modulation spatiale de lumière (15) est un modulateur spatial de lumière effectuant une modulation d'amplitude lumineuse sur la lumière, un modulateur spatial de lumière effectuant une modulation de phase de lumière sur la lumière ou un modulateur spatial de lumière effectuant une modulation de polarisation sur la lumière.

12. Système photolithographique selon la revendication 1, dans lequel la station mobile (19) est sélectionnée dans le groupe consistant en :
une station mobile tridimensionnelle consistant en trois stations mobiles à déplacement linéaire indépendantes ;
une station mobile tridimensionnelle consistant en une station mobile à montage en parallèle bidimensionnelle et une station mobile indépendante ;
une station mobile à montage en parallèle tridimensionnelle ; ou
une station mobile multidimensionnelle consistant en des stations mobiles avec des fonctions de rotation et d'inclinaison,
dans lequel une plage de déplacement est de 0,1 µm à 1 m, un angle de rotation est de 0 à 360° et un angle d'inclinaison est de -90° à +90°.

13. Système photolithographique selon la revendication 1, dans lequel l'unité de calcul et de commande (20) comprend :
une partie de lecture de données lisant le motif devant être exposé ;
une partie de traitement de données décomposant le motif devant être exposé ;
et
une partie de commande commandant la station mobile (19), l'unité d'exposition par balayage laser point par point et l'unité d'exposition par projection plane pour fonctionner de manière coopérative.
